# EUROPÄISCHE PATENTSCHRIFT

(11) **EP 2 047 530 B1**
(45) Veröffentlichungstag und Bekanntmachung des Hinweises auf die Patenterteilung: **31.08.2016**
(21) Anmeldenummer: 07817408.3
(22) Anmeldetag: 26.07.2007
(51) Int. Cl.: H01L 41/053, F16F 1/02

(54) **FEDERELEMENT SOWIE PIEZOAKTOR MIT DEM FEDERELEMENT**
SPRING ELEMENT AND PIEZOELECTRIC ACTUATOR WITH THE SPRING ELEMENT
ÉLÉMENT DE RESSORT ET PIÉZOACTIONNEUR AVEC L'ÉLÉMENT DE RESSORT

(30) Priorität: 28.07.2006 DE 102006035038
(43) Veröffentlichungstag der Anmeldung: 15.04.2009
(73) Patentinhaber: Epcos AG, 81669 München (DE)
(72) Erfinder: STOCKER, Werner, 8792 St. Peter Freien (AT); VERONIK, Franz, 8510 Stainz (AT); JAKOPE, Andreas, 8461 Ehrenhausen (AT); REINISCH, Manfred, 8522 Gr. St. Florian (AT)
(74) Vertreter: Epping - Hermann - Fischer
(86) Internationale Anmeldenummer: PCT/DE2007/001324
(87) Internationale Veröffentlichungsnummer: WO 2008/014759

(56) Entgegenhaltungen:
- EP-A- 0 881 042
- WO-A-03/033933
- DE-A1- 10 140 197
- DE-A1- 19 928 189
- DE-A1-102004 031 597
- DE-C- 693 338
- DE-C1- 19 854 508
- FR-A- 2 404 770
- US-A- 5 062 619

## Beschreibung

Es wird ein Federelement zur Verwendung mit einem Piezoaktor beschrieben.

Aus WO 2005/062395 ist ein Piezoaktor mit einem mit Aussparungen versehenes, rohrförmiges Federelement bekannt.

Aus US 2003/034594 A1 ist ebenfalls ein Piezoaktor mit einem mit Aussparungen versehenes, rohrförmiges Federelement bekannt.

Aus WO 03/033933 A1 geht eine Aktoreinheit hervor, bei der eine Rohrfeder längliche Ausnehmungen aufweist.

Aus JP 2002-58260 A geht ein Federelement für einen Piezoaktor hervor, bei dem eine Aussparung in Form einer Raute vorgesehen ist.

Eine zu lösende Aufgabe besteht darin, ein Vorspannelement bzw. einen Piezoaktor mit einem Vorspannelement zu schaffen, welches bzw. welcher lange fehlerfrei verwendbar ist.

Es wird ein Federelement zur Vorspannung eines Piezoaktors angegeben, das einen rohrförmigen Körper umfasst. Dieser weist Aussparungen mit abgerundeten Ecken auf. Der Umriss einer jeden Aussparung kann dabei Ecken aufweisen, die ausschließlich abgerundet sind.

Der rohrförmige Körper ist mit Aussparungen in der Form eines Vielecks ausgebildet, wobei die Ecken des Vielecks abgerundet sind. Die Aussparungen können dabei den Umriss einer kontinuierlichen, ununterbrochenen Linie aufweisen.

Die Aussparungen sind jeweils in der Form einer Raute mit abgerundeten Ecken ausgebildet.

Das Federelement kann ein piezoelektrisches Vielschichtbauelement eines Piezoaktors unter Druckspannung setzen, indem es beispielsweise eine geringere Höhe aufweist, als das Vielschichtbauelement und mechanisch mit den Stirnflächen des Vielschichtbauelements direkt oder indirekt, beispielsweise über Gegenlager, verbunden ist.

Vieleckige, insbesondere rautenförmige Aussparungen, die abgerundete Ecken aufweisen, haben den Vorteil, dass trotz der aufgrund der Aussparungen unterbrochenen Struktur des rohrförmiges Körpers keine für seine strukturelle Integrität gefährliche mechanische Spannungen entstehen können, wenn er mechanischen Spannungen ausgesetzt wird. Es hat sich beispielsweise herausgestellt, dass ein rohrförmiger Körper zur Vorspannung eines Piezoaktors, welcher mit Aussparungen versehen ist, die scharfe Kanten oder Ecken aufweisen, unter mechanischer Belastung Risse bilden kann.

Außerdem haben Aussparungen mit abgerundeten Ecken den Vorteil, dass die zum Ausstanzen der Aussparungen verwendete Schneidvorrichtung eines Stanzwerkzeugs weniger oft geschliffen bzw. geschärft werden muss. Es hat sich nämlich herausgestellt, dass Aussparungen mit abgerundeten Ecken sich gut ausstanzen lassen, auch wenn die Schneidvorrichtung bzw. Klinge eines Stanzwerkzeuges bereits abgestumpft ist. Der Wartungsaufwand sowie die Wartungskosten für das Stanzwerkzeug können daher vorteilhafterweise reduziert werden.

Auch haben Aussparungen mit abgerundeten Ecken einen Vorteil, wenn sich der rohrförmige Körper dehnt, zusammenzieht und dabei einknickt oder sich biegt. Es wurde nämlich beobachtet und festgestellt, dass sich beim Biegen des rohrförmigen Körpers mit rautenförmigen Aussparungen die Außenkontur des Rohrkörpers an der Biegestelle wenig ändert. Anders geformte Aussparungen, deren Ecken nicht abgerundet sind, führten dabei zu einer sich von einer Kreisform deutlich unterscheidenden Außenkonturform. Dies hatte jedoch einen negativen Effekt auf die mechanische Stabilität des rohrförmigen Körpers.

Gemäß der erfindungsgemäßen Ausführungsform des Federelements bilden die Aussparungen ein regelmäßiges Muster. Dadurch ergibt sich der Vorteil, dass die Verteilung von mechanischer Spannung durch den rohrförmigen Körper besonders gleichmäßig ist und größere mechanische Spannungsspitzen bei mechanischer Belastung nicht zu erwarten sind. Dabei sind die Aussparungen zeilenweise angeordnet, wobei jede Aussparung einer ersten Zeile in der Projektion entlang der Rohrachse in die Aussparung einer übernächste Zeile überführbar ist. Es wird dadurch ein gitterförmiges Aussparungsmuster angegeben, welches hinsichtlich mechanischer Stabilität, insbesondere Elastizität besonders günstig ist.

Mögliche Ausführungsformen des Federelements umfassen einen rohrförmigen Körper mit einer Außenkontur in der Form eines regelmäßigen Vielecks. Als Außenkontur wird die Form des rohrförmigen Körpers bezeichnet, die sich zeigt, wenn der rohrförmige Körper in der Draufsicht betrachtet wird bzw. wenn ein orthogonal zur Längsachse des rohrförmigen Körpers verlaufender Querschnitt des rohrförmigen Körpers betrachtet wird.

Es hat sich herausgestellt, dass eine sechseckige Form der Außenkontur bezüglich der mechanischen Stabilität des rohrförmigen Körpers besonders günstig ist. Oktagonale Außenkonturen haben sich dabei ebenfalls als günstig herausgestellt.

Der rohrförmige Körper kann auch eine Außenkontur mit einer kontinuierlich gekrümmten Form aufweisen. Dabei kommt beispielsweise für die Außenkontur eine kreisförmige Struktur oder eine gewellte oder abgeflachte kreisförmige Struktur in Betracht.

Der rohrförmige Körper könnte eine variierende Dicke aufweisen. Dort wo der rohrförmige Körper weniger dick ausgebildet ist, als in anderen Bereichen des Körpers, könnte er beispielsweise unter mechanischer Spannung leichter einknicken bzw. sich leichter biegen. Damit lässt sich der Bereich des rohrförmigen Körpers eingrenzen bzw. festlegen, der am stärksten geneigt ist, einzuknicken bzw. sich zu biegen. Gezielt in diesem Bereich könnte der rohrförmige Körper mit einer höheren Anzahl oder einer geringeren Anzahl von Aussparungen in der Form von Rauten mit abgerundeten Ecken versehen werden, um die dort die gewünschte Biegeeigenschaft bzw. Stabilität einzustellen.

Der rohrförmige Körper enthält vorzugsweise Materialien, die ihm eine langzeitstabile Elastizität aber gleichzeitig auch eine zur Vorspannung eines piezoelektrischen Vielschichtbauelements ausreichende Steifigkeit verleihen. Es können insbesondere federelastische Werkstoffe verwendet werden. Metalle bzw. Metalllegierungen werden dabei bevorzugt. Besonders bevorzugt werden Stahl oder Stahllegierungen, aber auch NE-Metalle. Es könnten jedoch auch Kunststoffe eingesetzt werden.

Es wird außerdem ein Piezoaktor angegeben der ein piezoelektrisches Vielschichtbauelement mit mehreren übereinander gestapelten piezoelektrischen Schichten und Elektrodenschichten aufweist. Die piezoelektrischen Schichten enthalten dabei vorzugsweise eine piezoelektrische Keramik, beispielsweise eine PZT Keramik. Der Piezoaktor weist zudem ein Federelement gemäß der beschriebenen Gegenstände auf, wobei das piezoelektrische Vielschichtbauelement zumindest teilweise innerhalb des Federelements angeordnet ist.

Das piezoelektrische Vielschichtbauelement kann mittels Übereinanderstapeln von keramischen Grünfolien, welche mit Elektrodenschichten versehen werden, und anschließendem Sintern geschaffen werden. Dabei wird vorzugsweise ein monolithisches Vielschichtbauelement geschaffen.

Das Federelement ist derart beschaffen und mit dem piezoelektrischen Vielschichtbauelement mechanisch verbunden, dass das piezoelektrische Vielschichtbauelement unter Druckspannung gesetzt werden kann.

Das Federelement ist gemäß einer Ausführungsform des Piezoaktors an seinen beiden Stirnseiten bzw. Stirnenden jeweils mit einem Gegenlager mechanisch verbunden. Die Gegenlager sind vorzugsweise jeweils mit einer Stirnfläche des elektrischen Vielschichtbauelements verbunden und klemmen diesen zusammen mit dem Federelement ein. Beispielsweise ist das Federelement mit zumindest einem der Gegenlager verschweißt. Die Gegenlager könnten beispielsweise als Kappen geformt sein.

Die Elektrodenschichten des piezoelektrischen Vielschichtbauelements können jeweils mit einem elektrischen Anschlusselement kontaktiert sein. Ein elektrisches Anschlusselement können dabei durch zumindest eines der Gegenlager hindurchgeführt sein, was als platzsparende Bauweise vorteilhaft ist.

Ein elektrisches Anschlusselement könnte dabei eine elektrische Zuleitung des Piezoaktors umfassen. Die Zuleitung könnte dabei als Anschlussdraht-, Kabel- oder Fahne ausgebildet sein.

Gemäß einer Ausführungsform des Piezoaktors umfasst ein elektrisches Anschlusselement eine auf der Oberfläche des piezoelektrischen Vielschichtbauelements aufgebrachte Kontaktierungsschicht, die mit Elektrodenschichten kontaktiert ist.

Die beschriebenen Gegenstände werden anhand der folgenden Figuren und Ausführungsbeispiele näher erläutert. Dabei zeigt:
- Figur 1: ein Federelement mit rautenförmigen Aussparungen,
- Figur 2: einen Piezoaktor mit einem Federelement, das rautenförmige Aussparungen aufweist,
- Figur 3: einen Piezoaktor,
- Figur 4: Querschnitte unterschiedlich geformter Federelemente.

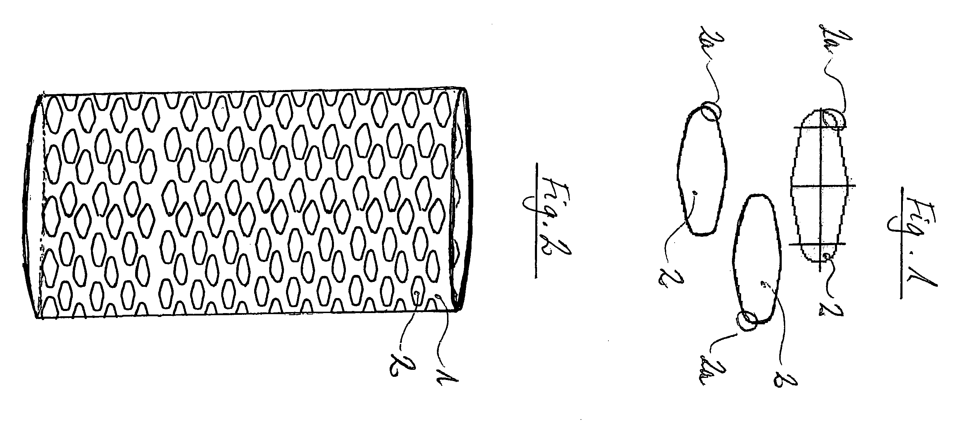

Figur 1 zeigt Rautenformen 2 mit abgerundeten Ecken, die als Aussparungen in einer Rohrfeder zur Vorspannung eines Piezoaktors Verwendung finden.

Figur 2 zeigt eine Rohrfeder 1, in der eine Vielzahl von rautenförmigen Aussparungen 2 in einem regelmäßig Muster eingearbeitet sind. Die Einarbeitung der Aussparungen könnte dabei mittels Stanzen bzw. mittels eines Stanzwerkzeugs erfolgen.

Die Aussparungen 2 sind dabei rautenförmig mit abgerundeten Ecken 2a ausgebildet. Derart geformte Aussparungen 2 haben den Vorteil, dass Kerbwirkungen zwischen bzw. an den Aussparungen vermieden werden können. Eine Kerbwirkung zeichnet sich dadurch aus, dass mechanische Spannungen an scharfkantigen bzw. scharfeckigen Bereichen eines Materials entstehen, die zu einem Materialbruch führen könnten. Da die vorgeschlagenen Aussparungen jedoch im jeweiligen Umfang keine scharfen Kanten aufweisen, bedeutet dies, dass die Struktur der Rohrfeder 1 neben bzw. entlang einer jeden Aussparung 2 ebenfalls keine scharfen Kanten aufweist. Somit können solche für die strukturelle Integrität der Rohrfeder gefährliche mechanische Spannungen nicht auftreten oder zumindest erheblich reduziert werden.

Das Material der Rohrfeder 1 zwischen den Aussparungen 2 wirkt als Biegeträger, weshalb die Federsteifigkeit gegenüber einem Vorspannungselement für einen Piezoaktor ohne Ausnehmungen stark herabgesetzt wird. Ein Biegeträger ist ein Träger bzw. ein Trägermaterial, das sich biegen bzw. verformen kann, ohne dass es dabei zerstört wird.

Aufgrund der gegenüber Kerbwirkungen weniger anfälligen Aussparungen kann zudem die Dauerfestigkeit der Rohrfeder erhöht werden, weil die Wahrscheinlichkeit der Entstehung von Mikrorissen herabgesetzt wird.

Da die rautenförmigen Aussparungen keine scharfen Ecken bzw. Kanten aufweisen, muss das Stanzwerkzeug, welches sie aus einem Federelement herausstanzt, weniger oft geschärft werden. Die Standzeit des Stanzwerkzeuges kann somit vorteilhafterweise erhöht werden.

Die rautenförmigen Aussparungen haben auch den Vorteil, dass sie geringere mechanische Spannungsspitzen innerhalb der Rohrfeder erlauben, die anderenfalls entstehen könnten, wenn die Rohrfeder scharfeckigen bzw. scharfkantigen Bereichen aufweisen würde.

Es hat sich ebenfalls herausgestellt, dass rautenförmige Aussparungen zu geringeren Rundheitsabweichungen der Außenkontur einer hohlzylinderförmigen Rohrfeder führen, wenn die Rohrfeder sich biegt bzw. komprimiert oder expandiert.

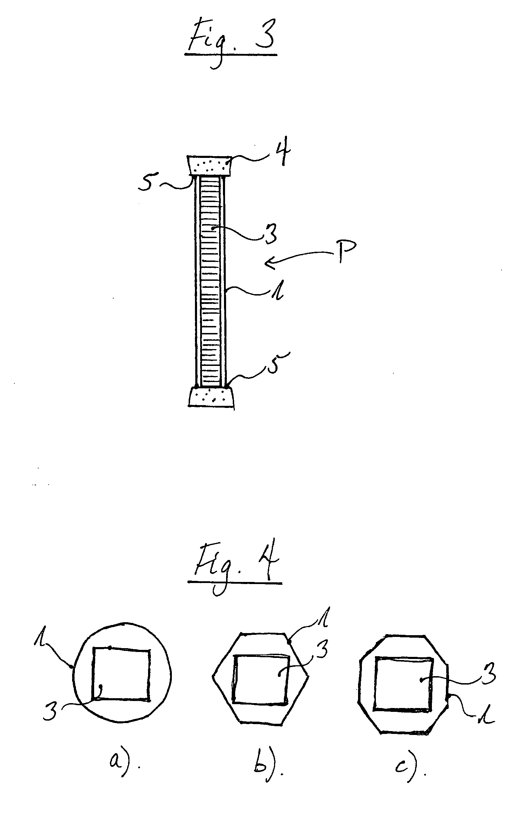

Figur 3 zeigt einen Piezoaktor P mit einem piezoelektrischen Vielschichtbauelement 3 und eine um das Bauelement gebildete Rohrfeder 1. Die Rohrfeder ist dabei mittels Verschweißen bzw. Schweißstellen 5 stirnseitig mit je einem Gegenlager 4 mechanisch verbunden. Die Rohrfeder ist zudem geringfügig weniger hoch ausgebildet, als das piezoelektrische Bauelement 3. Die Gegenlager werden hier schematisch gezeigt. Sie können jedoch Durchführungen bzw. Hohlräume für weitere Bauelemente des Piezoaktors enthalten bzw. mit ihnen mechanisch verbunden sein, wie beispielsweise elektrische Anschlusselemente oder eine Mechanik, wie zum Beispiel eine Auslenkmechanik, zur Betätigung eines Ventils. Das Ventil könnte Bestandteil einer Einspritzvorrichtung, insbesondere Kraftstoffeinspritzvorrichtung sein.

Obwohl beide Stirnseiten des rohrförmigen Körpers 1 mit einem Gegenlager 4 verbunden sein können, ist es möglich, stattdessen zumindest eine Stirnseite des rohrförmigen Körpers umzubiegen, wodurch eine Stirnfläche des piezoelektrischen Vielschichtbauelements zumindest teilweise durch einen Endbereich des rohrförmigen Körpers abgedeckt wird. So könnte das andere Ende des rohrförmigen Körpers mit einem Gegenlager verbunden werden, wobei dieses Ende des rohrförmigen Körpers vorzugsweise nicht ganz bis zum Gegenlager reicht. Eine Verbindung der beiden Bauteile könnte beispielsweise mittels Schweißen dem piezoelektrischen Vielschichtbauelement die benötigte Vorspannung geben.

Figur 4 zeigt in einer Draufsicht verschiedene Ausführungsformen a., b. und c. der Außenkontur eines rohrförmigen Körpers 1, in dem ein piezoelektrisches Vielschichtbauelement 1 eingeführt ist. Es werden kreisförmige, sechseckförmige und achteckförmige Außenkonturen gezeigt.

### Bezugszeichenliste

- P: Piezoaktor
- 1: rohrförmiges Vorspannungselement
- 2: rautenförmige Aussparung mit abgerundeten Ecken
- 2a: abgerundete Ecke
- 3: piezoelektrisches Vielschichtbauelement
- 4: Gegenlager
- 5: Schweißstelle

## Patentansprüche

1. Federelement zur Vorspannung eines Piezoaktors (P), umfassend einen rohrförmigen Körper (1), der Aussparungen (2) aufweist, wobei die Aussparungen jeweils in der Form von Rauten mit abgerundeten Ecken (2a) gebildet sind, **dadurch gekennzeichnet, dass** die Anordnung der Aussparungen (2) ein regelmäßiges Muster bildet, wobei die Aussparungen (2) zeilenweise angeordnet sind, wobei jede Aussparung einer ersten Zeile in der Projektion entlang der Rohrachse in die Aussparung (2) einer übernächsten Zeile überführbar ist

2. Federelement nach Anspruch 1, bei dem die Umrisse der Aussparungen (2) Ecken (2a) aufweisen, die ausschließlich abgerundet sind.

3. Federelement nach einem der vorhergehenden Ansprüche, bei dem der rohrförmige Körper (1) eine Außenkontur in der Form eines regelmäßigen Vielecks aufweist.

4. Federelement nach einem der Ansprüche 1 oder 2, bei
dem der rohrförmige Körper (1) eine Außenkontur mit einer kontinuierlich gekrümmten Form aufweist.

5. Federelement nach einem der vorhergehenden Ansprüche, bei dem der rohrförmige Körper (1) nahtlos ausgebildet ist.

6. Federelement nach einem der vorhergehenden Ansprüche, bei dem der rohrförmige Körper (1) eine variierende Dicke aufweist.

7. Federelement nach Anspruch 6, bei dem der rohrförmige Körper (1) profiliert ist.

8. Piezoaktor (P), umfassend:
- ein piezoelektrisches Vielschichtbauelement (3) mit mehreren übereinander gestapelten piezoelektrischen Schichten und Elektrodenschichten,
- ein Federelement nach einem der vorhergehenden Ansprüche, wobei das piezoelektrische Vielschichtbauelement zumindest teilweise innerhalb des Federelements angeordnet ist.

9. Piezoaktor (P) nach Anspruch 8, bei dem das Federelement das piezoelektrische Vielschichtbauelement (3) unter Druckspannung setzt.

10. Piezoaktor (P) nach einem der Ansprüche 8 oder 9, bei dem das Federelement an seinen beiden Stirnseiten mit je einem Gegenlager (4) verbunden ist, die das elektrische Vielschichtbauelement (3) ober- und unterseitig einklemmen.

11. Piezoaktor (P) nach einem der Ansprüche 8 bis 10, bei dem jede Elektrodenschicht mit einem elektrischen Anschlusselement kontaktiert ist.

12. Piezoaktor (P) nach Anspruch 11, bei dem zumindest eines der elektrischen Anschlusselemente durch zumindest eines der Gegenlager (4) hindurchgeführt ist.

## Claims

1. Spring element for preloading a piezo actuator (P), comprising a tubular body (1) which has cutouts (2), wherein the cutouts are each formed in the shape of rhombuses with rounded corners (2a), **characterized in that** the arrangement of the cutouts (2) forms a regular pattern, wherein the cutouts (2) are arranged in rows, wherein each cutout of a first row can be transferred to the cutout (2) of a row after next in the projection along the tube axis.

2. Spring element according to Claim 1, in which the outlines of the cutouts (2) have corners (2a) which are exclusively rounded.

3. Spring element according to either of the preceding claims, in which the tubular body (1) has an outer contour in the shape of a regular polygon.

4. Spring element according to either of Claims 1 and 2, in which the tubular body (1) has an outer contour with a continuously curved shape.

5. Spring element according to one of the preceding claims, in which the tubular body (1) is of seamless design.

6. Spring element according to one of the preceding claims, in which the tubular body (1) has a varying thickness.

7. Spring element according to Claim 6, in which the tubular body (1) is profiled.

8. Piezo actuator (P), comprising:
- a piezoelectric multilayer component (3) with a plurality of piezoelectric layers and electrode layers which are stacked one above the other,
- a spring element according to one of the preceding claims, wherein the piezoelectric multilayer component is arranged at least partially within the spring element.

9. Piezo actuator (P) according to Claim 8, in which the spring element places the piezoelectric multilayer component (3) under compressive stress.

10. Piezo actuator (P) according to either of Claims 8 and 9, in which the spring element is connected at its two end faces to in each case one mating bearing (4) which clamps the electrical multilayer component (3) at the top and at the bottom.

11. Piezo actuator (P) according to one of Claims 8 to 10, in which contact is made with each electrode layer by an electrical connection element.

12. Piezo actuator (P) according to Claim 11, in which at least one of the electrical connection elements is routed through at least one of the mating bearings (4).

## Revendications

1. Élément à ressort, destiné à précontraindre un actionneur piézoélectrique (P), comprenant un corps (1) de forme tubulaire, qui comporte des évidements (2), les évidements étant formés chacun sous la forme de losanges avec des angles (2a) arrondis, **caractérisé en ce que** le placement des évidements (2) forme un motif régulier, les évidements (2) étant placés à la manière de lignes, chaque évidement d'une première ligne dans la projection le long de l'axe du tube pouvant passer dans l'évidement (2) d'une ligne après la suivante.

2. Élément à ressort selon la revendication 1, sur lequel les tracés des évidements (2) comportent des angles (2a) qui sont exclusivement arrondis.

3. Élément à ressort selon l'une quelconque des revendications précédentes, sur lequel le corps (1) de forme tubulaire présente un contour extérieur de la forme d'un polygone régulier.

4. Élément à ressort selon l'une quelconque des revendications 1 ou 2, sur lequel le corps (1) de forme tubulaire présente un contour extérieur de forme recourbée en continu.

5. Élément à ressort selon l'une quelconque des revendications précédentes, sur lequel le corps (1) de forme tubulaire est conçu sans soudure.

6. Élément à ressort selon l'une quelconque des revendications précédentes, sur lequel le corps (1) de forme tubulaire présente une épaisseur variable.

7. Élément à ressort selon la revendication 6, sur lequel le corps (1) de forme tubulaire est profilé.

8. Actionneur piézoélectrique (P), comprenant :
- un élément constitutif multicouches (3) piézoélectrique avec plusieurs couches piézoélectriques empilées les unes sur les autres et des couches d'électrodes,
- un élément à ressort selon l'une quelconque des revendications précédentes, l'élément constitutif multicouches piézoélectrique étant placé au moins en partie à l'intérieur de l'élément à ressort.

9. Actionneur piézoélectrique (P) selon la revendication 8, sur lequel l'élément à ressort place l'élément constitutif multicouches (3) piézoélectrique sous tension de compression.

10. Actionneur piézoélectrique (P) selon l'une quelconque des revendications 8 ou 9, sur lequel sur ses deux faces frontales, l'élément à ressort est relié avec chaque fois un palier-support (4) qui enserre l'élément constitutif multicouches (3) électrique sur le côté supérieur ou sur le côté inférieur.

11. Actionneur piézoélectrique (P) selon l'une quelconque des revendications 8 à 10, sur lequel chaque couche d'électrodes est en contact avec un élément de raccordement électrique.

12. Actionneur piézoélectrique (P) selon la revendication 11, sur lequel au moins l'un des éléments de raccordement électriques est guidé à travers au moins l'un des paliers-supports (4).
